Europäisches Patentamt

European Patent Office

Office européen des brevets

(11) Veröffentlichungsnummer: **0 157 135**
**B1**

(12) **EUROPÄISCHE PATENTSCHRIFT**

(45) Veröffentlichungstag der Patentschrift: **05.09.90**

(51) Int. Cl.⁵: **G 01 R 15/08**

(21) Anmeldenummer: **85101679.0**

(22) Anmeldetag: **15.02.85**

(54) Verfahren zur Messwertanzeige.

(30) Priorität: **05.03.84 DE 3408026**

(43) Veröffentlichungstag der Anmeldung:
**09.10.85 Patentblatt 85/41**

(45) Bekanntmachung des Hinweises auf die
Patenterteilung:
**05.09.90 Patentblatt 90/36**

(84) Benannte Vertragsstaaten:
**DE FR GB IT NL**

(56) Entgegenhaltungen:
EP-A-0 158 783
CH-C- 531 723
DE-A-3 238 487
DE-C-2 141 361
US-A-3 958 178
US-A-4 386 347

(73) Patentinhaber: **Asea Brown Boveri
Aktiengesellschaft
Kallstadter Strasse 1
D-6800 Mannheim-Käfertal (DE)**

(72) Erfinder: **Heinze, Siegfried, Dipl.-Ing.
Neidsteiner Strasse 6
D-8500 Nürnberg (DE)**
Erfinder: **Haussel, Werner
Ahornstrasse 51
D-8501 Feucht (DE)**
Erfinder: **Kern, Reinhold
Jurastrasse 4
D-8430 Neumarkt (DE)**
Erfinder: **Roppelt, Günter
Rotbuchenstrasse 33
D-8500 Nürnberg (DE)**

(74) Vertreter: **Rupprecht, Klaus, Dipl.-Ing. et al
c/o Asea Brown Boveri Aktiengesellschaft
Zentralbereich Patente Postfach 100351
D-6800 Mannheim 1 (DE)**

Courier Press, Leamington Spa, England.

**Beschreibung**

Die Erfindung betrifft zwei Verfahren zur Meßwertanzeige der Art, daß auf einem Display eine quasianaloge Darstellung der Meßwerte erfolgt und die Meßwertskala aus einem vorgegebenen Gesamtmeßbereich einen gespreizten Meßbereichsausschnitt wiedergibt, dessen Spreizungsfaktor veränderbar ist.

Digitale Meßgeräte haben gegenüber analogen Meßgeräten den wesentlichen Vorteil, daß sich ihre Anzeigegenauigkeit nahezu beliebig erhöhen läßt. Zur Verbesserung der Anzeigegenauigkeit bedarf es nicht wie beim analogen Meßgerät einer Verlängerung der Skala, der durch die Größe des Meßgerätes enge Grenzen gesetzt sind, sondern die nummerische Anzeige muß lediglich durch eine oder mehrere Stellen erweitert werden. Vorteilhaft ist es auch, daß eine stehende nummerische Anzeige ohne Schwierigkeiten bis zur letzten Stelle abgelesen werden kann, während eine analoge Anzeige durch Parallaxenfehler oder falsche Bewertung der Skala in Bezug zum eingestellten Meßbereich leicht zu Ablesefehlern führt.

Den Vorteilen der numerischen Anzeige stehen jedoch Nachteile gegenüber, sobald sich der Meßwert nicht statisch sondern dynamisch verhält. Meßwertänderungen führen zu einem ständigen Wechsel der numerischen Anzeige, dem das Auge des Betrachters weder zur Erfassung des momentanen Absolutwertes noch der Änderungstendenz folgen kann. Diesbezüglich zeigt sich die Analoganzeige überlegen, bei der mit einem Blick die jeweilige Lage des Meßzeigers erfaßt werden kann und sowohl der grobe Absolutwert wie auch die Änderungstendenz sichtbar werden.

Es ist deshalb eine Vielzahl von Meßgeräten bekannt geworden, bei denen eine nummerische Anzeige mit einer analogen Anzeige kombiniert ist, um die Vorteile beider Anzeigearten zu verbinden. Dabei hat es sich als zweckmäßig herausgestellt, die relativ empfindlichen elektromagnetischen Analogmeßwerke durch elektronische quasi analog anzeigende Displays zu ersetzen. Ein solches Display besteht aus mehreren, kettenförmig aneinandergereihten Leuchtdioden oder Flüssigkristallsegmenten, die, wie z.B. in der DE—B—21 41 361 beschrieben, über eine elektronische Schaltung einzeln ansteuerbar sind. Flüssigkristalle werden nicht nur wegen ihres geringen Leistungsbedarf bevorzugt, sondern haben auch den Vorteil, daß die einzeln ansteuerbaren Flächensegmente in ihrer Form nahezu beliebig an den jeweiligen Anwendungsfall anpaßbar sind.

Zur Nachbildung einer bestimmten Zeigerstellung wird jeweils das Flächensegment eines Flüssigkristall-Displays angesteuert, dessen Lage der zu simulierenden Zeigerstellung am nächsten kommt. Wird nicht nur dieses, eine Flächensegment sondern werden alle davorliegenden Flächensegmente angesteuert, so spricht man von einer Balkenanzeige oder Bandanzeige, die den Meßwert auch aus größerer Entfernung noch erkennbar werden läßt.

Aus der DE-A-32 38 487 ist ein digitales Meßgerät bekannt, das ebenfalls ein Flüssigkristall-Display zur quasi analogen Anzeige besitzt, jedoch zusätzlich durch die gespreizte Darstellung eines Teilbereiches die Ablesegenauigkeit verbessert. Da die Spreizung im Bereich eines vorzugsweise in Skalenmitte angeordneten Sollwertes erfolgt, ist auch bei kleinen Meßwertänderungen gut erkennbar, ob sich der Meßwert dem Sollwert nähert.

Das bekannte Meßgerät ist bezüglich seines gespreizten. Meßbereichsausschnittes auf einen Sollwert fixiert und somit für normale, sollwertunabhängige Messungen nicht geeignet. Außerdem kann der Meßwert nicht in Absolutwerten abgelesen werden, sondern ist als prozentuale Abweichung zum Sollwert dargestellt, was eine umständliche Berechnung des Meßwertes erfordert. Nachteilig ist weiterhin, daß nur ein fest eingestellter Meßbereichsausschnitt vorgesehen ist. Ein sich aus dem Meßbereichsausschnitt herausbewegender Meßwert wird dadurch unsichtbar. Die Entscheidung, ob mit oder ohne Meßbereichsspreizung gemessen werden soll, bleibt dem Bedienpersonal überlassen. Da die Entscheidung zunächst einen Meßvorgang erfordert, dauert sie entsprechend lange.

Weiterhin ist aus CH-C-531 723 eine elektronische Meßvorrichtung bekannt, die eine kombinierte digitale und analoge Meßwertanzeige enthält. Die analoge Meßwertanzeige ist mit einer festen Skala versehen, die aus einem vorgesehenen Gesamtmeßbereich einen Teilbereich zur Anzeige bringen kann. Der Teilbereich ist so auf die Digitalanzeige abgestimmt, daß nach jedem Durchlaufen eines Teilbereiches die Digitalanzeige um ein Digit steigt Diese Verkopplung des Teilbereiches mit der Digitalanzeige bedeutet selbstverständlich eine erhebliche Einschränkung sowohl bei der Gestaltung wie auch beim Gebrauch des Meßgerätes. Nachteilig ist vor allem, daß der momentane Meßwert nur durch Addition des auf der Digitalanzeige angezeigten Meßwertes mit dem Meßwert der Analoganzeige ermittelt werden kann.

Die ältere nicht vorveröffentlichte EP-A-0 158 783 beschreibt ein digitales Meßgerät, bei dem auf einem Display eine quasianaloge Darstellung des Meßwertes erfolgt, indem ansteuerbare Flächensegmente entlang einer Meßwertskala mit zugehöriger Beschriftung ihre Stellung als Zeigermarke oder Balkenanzeige ändern. Die Meßwertskala gibt aus einem vorgegebenen Gesamtmeßbereich einen gespreizten Meßbereichsausschnitt wieder, dessen Spreizungsfaktor einstellbar ist. Der Meßbereichsausschnitt wird bei gleichbleibendem Gesamtmeßbereich einschließlich zugehöriger Skalenwerte durch eine Steuerautomatik umgeschaltet, sobald die Meßwerte vorgegebene Grenzwerte des Meßbereichsausschnittes überschreiten. Die ältere europäische Anmeldung zeigt jedoch keine Lösung auf, wie ein ständiges Umschalten des Meßbereichsausschnitts bei hoher Änderungsgeschwindigkeit der Meßwerte vermieden werden kann bzw. wie beim Abgleich eines Meßwertes die jeweils größte Skalenauflösung erzielbar ist.

Aufgabe der Erfindung ist es ein Verfahren zu schaffen, das Tendenzbeobachtungen sowohl sehr kleiner, als auch großer Meßwertänderungen sowie ein, analoges Ablesen des Meßwertes innerhalb des gewählten Meßbereiches erlaubt und bei dem der Meßwert trotz hoher Skalenauflösung im jeweiligen Skalenausschnitt sichtbar bleibt.

Diese Aufgabe wird durch die im Anspruch 1 gekennzeichneten Merkmale für Meßabläufe gelöst, bei denen sich die Meßwerte unbeeinflußbar über den gesamten Meßbereich hinweg mit unbekannter Geschwindigkeit ändern können. Durch Ermittlung der Meßwertänderung pro Zeiteinheit gelingt es mit Hilfe einer Steuerautomatik den Spreizungsfaktor so zu optimieren, daß große Änderungsgeschwindigkeiten nicht zu unerwünscht schnellem Umschalten der Meßbereichsausschnitte führen. Der Spreizungsfaktor wird vielmehr so gewählt, daß — eine gleichbleibende Änderungsgeschwindigkeit vorausgesetzt — die Meßwerte während eines vorgegebenen Zeitraums bestimmte Grenzwerte des Meßbereichsausschnittes nicht überschreiten. Hierdurch ist sichergestellt, daß die Spreizung weder zu groß noch zu klein, sondern durch die Steuerautomatik so groß wie erwünscht eingestellt wird.

Die gleiche Aufgabe wird durch die in Anspruch 2 gekennzeichneten Merkmale für Meßabläufe gelöst, bei denen die Meßwerte im Rahmen eines Abgleichs auf einen vorgegebenen Referenzwert entstehen. Hier können sich die Meßwerte nur bei Beginn des Abgleichs in einem Bereich bewegen, der zunächst unbekannt ist. Mit fortschreitendem Abgleich nähern sich die Meßwerte jedoch dem Referenzwert. Da die Steuerautomatik zunächst dafür sorgt, daß der dargestellte Meßbereichsausschnitt dem jeweils vorzugebenden Referenzwert nachgeführt wird und sie den Spreizungsfaktor so wählt, daß der jeweilige Meßwert einen größtmöglichen Abstand zum Referenzwert erhält — allerdings ohne den Meßbereichsausschnitt zu verlassen — ergeben sich optimale Abgleichbedingungen. Der Abgleich wird in der Regel ohne oder bei geringer Spreizung beginnen, um den Meßwert "einzufangen". In dem Maße, in dem sich während des Abgleichs der Meßwert dem in Skalenmitte positionierten Referenzwert nähert, erhöht die Steuerautomatik den Spreizungsfaktor und erleichtert dadurch den Feinabgleich. Die stufige Änderung des Spreizungsfaktors sorgt dafür, daß die Umschaltung des Meßbereichsausschnittes als solche erkannt und nicht für eine Auswirkung des Abgleichs gehalten wird.

Eine Weiterbildung der Verfahren nach Anspruch 1 und 2 sieht zur Anpassung des Meßwertes eine Meßwerteingabeeinheit vor, deren Ausgangssignale einerseits zur Erfassung der Bereichsparameter direkt und andererseits über eine Anpaßschaltung und einen AD-Wandler einem Mikrocomputer zugeführt werden. Der Mikrocomputer bewirkt eine Umsetzung des Meßwertes in einzelne zur Aktivierung der Flächensegmente des Displays erforderliche Steuersignale, die er über einen Anzeigentreiber diesem zuführt. Über eine Bedienungseinheit werden dem Mikrocomputer Parameter wie Betriebsmodus, Meßbereich, Faktor für die Spreizung des Meßbereichsausschnittes und weitere die Ansteuerung der Flächensegmente bestimmende Kriterien vorgegeben.

Das Umschaltverhalten der Steuerautomatik kann außer durch die bereits genannten Möglichkeiten zur Optimierung des Spreizungsfaktors auch durch die Stufigkeit des Spreizungsfaktors beeinflußt werden. So sieht eine zweckmäßige Weiterbildung der Erfindung vor, die Zahl und den Abstand der Stufen des veränderbaren Spreizungsfaktors sowie den maximalen Spreizungsfaktor von Hand einstellbar zu machen.

Auch wenn durch die Steuerautomatik der Meßbereichsausschnitt dem Meßwert nachgeführt wird, und damit innerhalb des eingestellten Gesamtmeßbereiches der Meßwert immer sichtbar bleibt, ist es von Vorteil außer dem Meßbereichsausschnitt auch den Gesamtmeßbereich sichtbar zu machen. Das ist einerseits in der Form möglich, daß parallel zu dem gespreizten Meßbereichsausschnitt eine zweite Skala für den Gesamtmeßbereich abgebildet wird. Noch günstiger ist jedoch, beide Meßbereiche auf einer gemeinsamen Skala darzustellen. Insbesondere dann, wenn mit einer Verzögerungszeit für die Umschaltung der Meßbereichsausschnitte gearbeitet wird, ist es vorteilhaft den außerhalb des Meßbereichsausschnittes liegenden Meßwert noch bewerten zu können.

Die Darstellung der Skala mit zugehöriger Beschriftung und Zeigermarke auf einem Display, kann recht unterschiedlich ausgeführt sein. Man verwendet normalerweise Flüssigkristalle, die in eine Vielzahl einzelner Flächensegmente unterteilt sind und z.B. über eine Matrix angesteuert werden. Alle Flächensegmente sind hierbei gleich groß und etwa punktförmig ausgebildet. Eine solche Matrixsteuertechnik hat den Vorteil, daß praktisch beliebige Bilder dargestellt werden können, deren Qualität lediglich durch die Auflösung des Punktrasters begrenzt ist. Nachteilig ist allerdings der hohe Schaltungsaufwand für die Ansteuermimik und der komplizierte Aufbau des Displays. Eine wesentliche Vereinfachung läßt sich dadurch erzielen, daß die Flächensegmente des Displays in ihrer Form an die vorgegebenen Skalenvarianten angepaßt sind und sich bezüglich ihrer Flächenausdehnung, teilweise stark unterscheiden. Die Zahl der anzusteuernden Flächensegmente kann hierdurch erheblich reduziert werden. Gleichzeitig ist es möglich im Vergleich zur Matrixsteuertechnik mit einer niedrigeren Multiplexrate zu arbeiten und trotzdem mit weniger Zuführungsleitungen auszukommen.

Eine weitere Vereinfachung der Steuermimik ist dadurch erreichbar, daß die Skala eine feste Skalenteilung besitzt, die unabhängig vom gewählten Gesamtmeßbereich und dem jeweiligen Meßbereichsausschnitt gleich bleibt. Nur die Länge der Skalenstriche und die Beschriftung der Skalen unterliegt einer Änderung zur Anpassung an den jeweiligen Meßbereich. Die invariablen Teile der Skala können dabei gemeinsam angesteuert oder durch Aufdruck fest vorgegeben werden.

Die zur Darstellung der Zeigermarke ansteuerbaren Flächensegmente liegen in gleichem Abstand parallel nebeneinander vom Skalenanfang bis zum Skalenende. Die Zahl und Position dieser Flächensegmente ist so gewählt, daß an jedem Teilungsstrich der Skala ein Flächensegment für die Zeigermarke zu liegen kommt und weitere Flächensegmente zwischen den Teilungsstrichen angeordnet sind.

Zur besseren Ablesbarkeit ist sowohl im Meßbereichsausschnitt, wie auch in dem ihn einschließenden Gesamtmeßbereich eine lineare Teilung für die Sprünge der Zeigermarke vorgesehen. Dabei handelt es sich jedoch im Bereich des Meßbereichsausschnitts um eine lineare Spreizung und außerhalb seiner Grenzen um eine lineare Drängung. Das Überschreiten des Gesamtmeßbereiches wird durch eine Überlaufmarke signalisiert.

Damit der Schaltungsaufwand für die Ansteuerung des Displays in Grenzen gehalten wird, werden nur der Anfangs- und Endwert des Meßbereichsausschnittes sowie des Gesamtmeßbereichs und im allgemeinen auch der Skalenmittenwert durch den Meßbereich kennzeichnende alphanummerische Zeichen angezeigt. Zur Anzeige des momentanen Meßwertes also des Istwertes, dient eine zusätzliche flächenmäßig wesentlich größere Ziffernanzeige oberhalb oder unterhalb der Skala.

Eine fest vorgegebene Skala mit variabler Länge der Skalenstriche erfordert eine Skalenanpassung, die dafür sorgt, daß bei einer Umschaltung des Meßbereiches die längeren Skalenstriche an einer Stelle zu liegen kommen, die eine leicht lesbare Unterteilung des eingestellten Meßbereiches gewährleistet. Es muß weiterhin dafür gesorgt werden, daß nach einer Grobeinstellung des Spreizungsfaktors von Hand oder einer automatischen Einstellung in Abhängigkeit von bestimmten Parametern eine Feineinstellung derart erfolgt, daß der zur Darstellung kommende Meßbereichsausschnitt zu der fest vorgegebenen Skalenteilung paßt.

Die Anpassung der Skalenteilung und -beschriftung an den jeweiligen Meßbereich führt zu einer wesentlichen Vereinfachung der Meßwertablesung. Denn es muß nun nicht mehr eine von mehreren Skalen des Vielfachmeßgerätes nach Meßbereich und Meßgröße richtig zugeordnet und bewertet werden. Unabhängig von Zahl und Art der Meßbereiche und Meßgrößen kommt jeweils nur eine Skala zur Anzeige und diese besitzt eine so ausgelegte Skalenteilung, daß in jedem Fall eine optimale Ablesbarkeit gewährleistet ist.

Bei dem Verfahren nach Anspruch 1 ist es möglich, ein Hin- und Herschalten von einem Meßbereichsausschnitt in den nächsten, durch einen im Grenzbereich pendelnden Meßwert zu vermeiden. Überschreitet der Meßwert den Anfang oder das Ende des Meßbereichsausschnittes, so gelangt er gemäß einer Weiterbildung der Erfindung im benachbarten Meßbereichsausschnitt nicht an dessen Ende oder Anfang, sondern in dessen Mitte. Die Meßbereichsausschnitte werden also so umgeschaltet, daß sie sich jeweils zur Hälfte überlappen.

Unterstützt wird die vorbeschriebene Maßnahme noch, wenn die Umschaltung nicht spontan erfolgt, sobald der Meßwert den oberen oder unteren Grenzwert des Meßbereichsausschnittes erreicht, sondern erst dann, wenn er einen der beiden Grenzwerte bereits eine bestimmte, vorgebbare Zeit überschritten hat Kehrt der Meßwert z.B. bei Störimpulsen während der Verzögerungszeit in den ursprünglichen Meßbereichsausschnitt zurück, so erfolgt keine Umschaltung.

Ein Ausführungsbeispiel des Gerätes zur Durchführung des erfindungsgemäßen Verfahrens wird im folgenden näher beschrieben und ist in den Zeichnungen dargestellt.

Es zeigen:

Figur 1: Eine Draufsicht auf das Display und die Bedienungselemente eines Vielfachmeßgerätes.

Figur 2: Einen Ausschnitt aus dem Display, auf dem eine Skala für den Gesamtmeßbereich und eine für den Meßbereichsausschnitt dargestellt sind.

Figur 3: Die Darstellung von drei Skalen, die alle jeweils den Gesamtmeßbereich und einen Meßbereichsausschnitt auf einer gemeinsamen Skala darstellen, sich jedoch durch den jeweiligen Meßbereichsausschnitt unterscheiden.

Figur 4: Ein Blockschaltbild des Meßgerätes.

Figur 5: Die Anordnung getrennt ansteuerbarer Flächensegmente zur Darstellung unterschiedlicher Skalenteilungen.

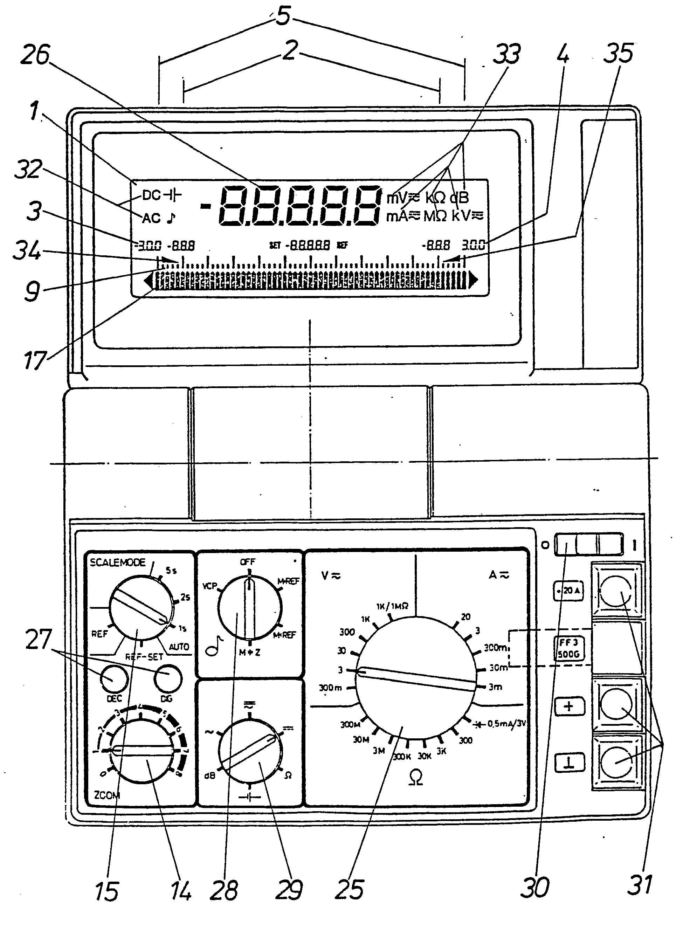

Das in Figur 1 dargestellte Vielfachmeßgerät besitzt ein aus Flüssigkristallen aufgebautes Display 1 zur Meßwertanzeige und mehrere Schalter und Taster zum Einstellen der verschiedenen, die Anzeige beeinflussenden Parameter. Auf dem Display wird der jeweilige Meßwert mit einer großflächigen Ziffernanzeige 26 und zusätzlich mit einer quasi analogen Skala 9 zur Anzeige gebracht.

Auf der Skala 9 ist ein Gesamtmeßbereich 5 und ein gespreizter Meßbereichsausschnitt 2 dargestellt. Die Skala 9 besitzt durchgehend eine lineare Skalenteilung, ungeachtet der Tatsache, daß sich für die Gesamtskala außerhalb des Meßbereichsausschnittes eine dessen Spreizung ausgleichende Drängung ergibt. Der gedrängte Bereich ist von dem gespreizten Bereich durch Dreieckmarken 34, 35 deutlich abgehoben. Hierdurch entsteht auch symbolisch der Eindruck einer zwischen den Spitzen der beiden Dreieckmarken 34, 35 liegenden Lupe. die zu einer gespreizten Darstellung des Meßbereichsausschnittes 2 führt.

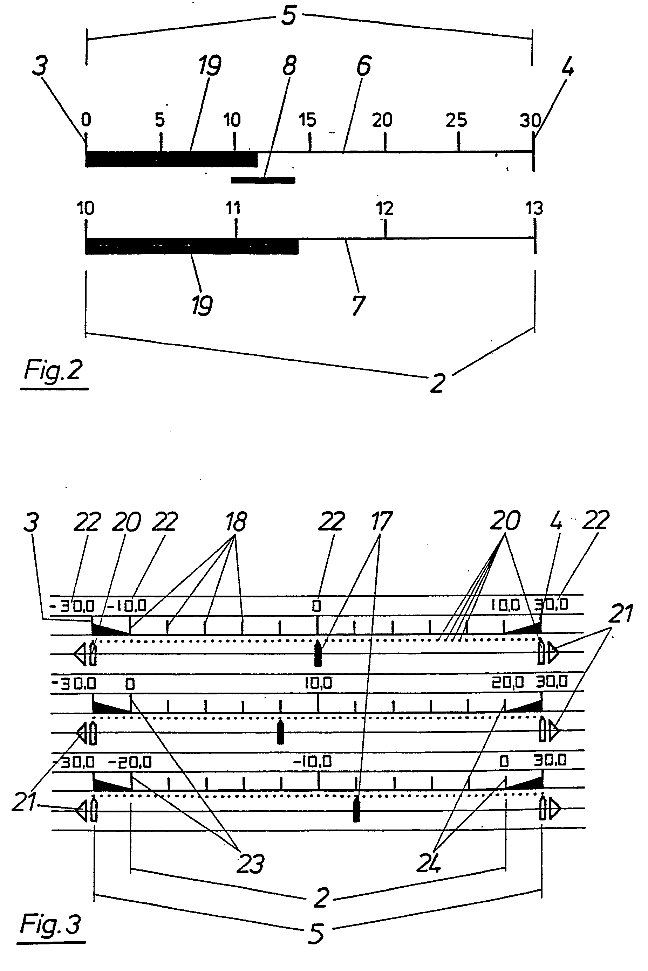

Wie besonders aus Figur 3 ersichtlich, sind unterhalb der Skala Flächensegmente 20 angeordnet, von denen jeweils das dem Meßwert am nächsten liegende angesteuert wird, wodurch ein sich scheinbar bewegender Zeiger entsteht. Selbstverständlich kann der Meßwert aber auch durch einen Anzeigebalken 19 angezeigt werden, wie das in Figur 2 dargestellt ist.

Bei dem Ausführungsbeispiel nach Figur 2 sind auf einem Display zwei Skalen 6, 7 parallel übereinander angeordnet, von denen die eine Skala 6 den Gesamtmeßbereich 5 und die andere Skala 7 einen Meßbereichsausschnitt 2 anzeigt. Sowohl zur Auswahl, wie auch zur Sichtbarmachung des Meßbereichsausschnittes 2 ist Parallel zur Skala 6 für den Gesamtmeßbereich 5 ein Cursor 8 eingeblendet, dessen Lage und Breite den Meßbereichsausschnitt 2 definiert.

Durch die in Figur 3 dargestellte Zusammenfassung von Gesamtmeßbereich 5 und Meßbereichsausschnitt 2 auf einer gemeinsamen Skala, reduziert sich der Aufwand für die Ansteuermimik ganz beträchtlich. Zudem kann man die Gesamtanzeige auf einen Blick übersehen, ohne daß das Auge von einer Skala zur anderen wechseln muß. Der Meßbereichsausschnitt 2 ist jeweils so angeordnet, daß sein mittlerer Wert etwa in Skalenmitte zu liegen kommt. Dieser mittlere Wert erreicht nach Figur 3 bei der ersten Skala, deren Meßbereichsausschnitt zwischen -10,0 und +10,0 liegt, einen Wert von 0, bei der zweiten Skala deren Meßbereichsausschnitt zwischen 0 und +20,0 liegt, einen Wert von 10,0 und bei der dritten Skala deren Meßbereichsausschnitt zwischen -20,0 und 0 liegt einen Wert von -10,0. Um den Steueraufwand klein zu halten, werden maximal fünf Skalenwerte in Ziffern 22 angezeigt. Hierzu gehören der Skalenanfangswert 3 und der Skalenendwert 4 des Gesamtmeßbereiches 5, der Skalenanfangswert 23 und der Skalenendwert 24 des Meßbereichsausschnittes 2 sowie der mittlere Skalenwert.

Die Skala besitzt eine feste Skalenteilung, mit nur 13 auf den Gesamtmeßbereich entfallenden Skalenstrichen. Diese Skalenstrichanzahl ist besonders günstig für Skalen mit einer Dreierteilung. Bei dem vorliegenden Beispiel erfordern die meisten Meßbereiche eine Umschaltung in Dreierdekaden. Nimmt man zunächst an, für den Meßbereichsausschnitt sei ein Spreizungsfaktor von 1 gewählt, so gilt die Dreierteilung durchgehend für den gesamten Meßbereich. Eine Trennung zwischen Gesamtmeßbereich und Meßbereichsausschnitt besteht in diesem Fall nicht und es werden auch die Dreieckmarken 34, 35 ausgeblendet.

Für den Meßbereichsausschnitt sind elf Teilstriche unabhängig vom jeweils gewählten Spreizungsfaktor vorgesehen. Die elf Teilstriche, von denen der sechste in Skalenmitte liegt, sind besonders gut für einen Endwert von eins, zwei. vier oder fünf geeignet. Soll ein solcher Endwert bei einem Gesamtmeßbereich realisiert werden, so wird die Gesamtskala auf elf Teilstriche, durch Ausblenden des ersten und letzten der dreizehn Teilstriche, beschränkt, sofern ein Spreizungsfaktor von eins vorgesehen ist. Bei größeren Spreizungsfaktoren können auch bei einer einser, zweier, vierer oder fünfer Teilung dreizehn Teilstriche verwendet werden.

Auf die dreizehn Teilstriche der Skala entfallen einundsechzig Flächensegmente 20, die jeweils die Stellung des Meßwertzeigers markieren können. Bezogen auf die elf Teilstriche des Meßbereichsausschnittes sind es noch einundfünfzig Flächensegmente 20 für die Zeigerstellung.

Insbesondere für Abgleichaufgaben ist es sehr vorteilhaft, wenn ein beliebiger Referenzwert in Skalenmitte vorgegeben werden kann, auf den dann der Meßwert einzustellen ist. Da es sich bei einem solchen Referenzwert um einen "krummen" Wert mit mehreren Stellen hinter dem Komma handeln kann, würde dieser mit der fest vorgegebenen Skalenteilung kollidieren. Bei in Skalenmitte vorgegebenen Referenzwerten wird deshalb der Meßbereichsausschnitt nicht mit Skalennennwerten versehen, sondern mit Plus/Minus-Werten, die sich auf den Referenzwert beziehen und an die Skalenteilung angepaßt werden können.

Besonderheiten für die Displayansteuerung können sich im Übergangsbereich vom Meßbereichsausschnitt zum Gesamtmeßbereich ergeben. Fällt der Anfangs- oder Endwert des Gesamtmeßbereiches mit dem Anfangs- oder Endwert des Meßbereichsausschnittes zusammen, dann wird der jeweils gleiche Wert des Gesamtmeßbereiches ausgeblendet und die Skala verkürzt sich um einen Teilstrich. Wird, insbesondere durch entsprechende Referenzwertvorgabe, ein Meßbereichsausschnitt gewählt, der teilweise über die Grenzen des Gesamtmeßbereiches hinausgeht, so springt die Meßwertanzeige zunächst auf den Endwert des Gesamtmeßbereiches und dann zur Überlaufmarke 21.

Wie Figur 1 zeigt, ist die Spreizung des Meßbereichsausschnittes durch einen Zoom-Schalter 14 einstellbar. Dabei entspricht die Zoom-Stellung 0 einem Spreizungsfaktor von 1. Zum Auffinden des Meßbereichsausschnittes, in dem gerade der Meßwert liegt, ist eine Steuerautomatik vorgesehen. Diese verfolgt den Meßwert und bringt bei vorgegebenem Spreizungsfaktor jeweils den Meßbereichsausschnitt zur Anzeige, bei dem der momentane Meßwert etwa in die Skalenmitte fällt. Bei einer fortlaufenden Umschaltung des Meßbereichsausschnittes, z.B. bei stetig steigendem Meßwert, wird also nicht vom Skalenende auf den Skalenanfang des nächsten Meßbereichsausschnittes, sondern auf dessen Mitte, also nur um einen halben Meßbereichsausschnitt, weitergeschaltet.

Eine zusätzliche Maßnahme zur Verhinderung eines unerwünschten Hin- und Herschaltens zwischen zwei benachbarten Meßbereichsausschnitten bei pendelndem Meßwert besteht darin, daß ein Zeitschalter 15 vorgesehen ist. Mit diesem läßt sich eine Zeit einstellen, durch die das Umschalten des Meßbereichsausschnittes verzögert wird. Es wird dann quasi abgewartet, ob der Meßwert nicht wieder in die Ausgangsposition zurückkehrt, bevor die Umschaltung erfolgt.

Der Zeitschalter 15 ist in Figur 1 als Scalemode deklariert, weil er noch zusätzliche Schaltstellungen für die Vorgabe und das Einstellen eines Referenzwertes besitzt. Das Einstellen erfolgt bei "Ref.Set." durch einen Referenzwert-Eingabetaster 27. Ein Meßbereichs- und Meßgrößenumschalter 25 ist mit einem Meßartenschalter 29 kombiniert, der auch eine Überprüfung der Batteriespannung erlaubt.

Ein akustisches Signal läßt sich durch den Signalschalter 28 vorgeben. Es wird je nach Schalterstellung ausgelöst, wenn der Meßwert größer oder kleiner ist als der eingestellte Referenzwert oder ermöglicht in der Stellung "VCP" eine Frequenz- bzw. Impulsänderung, durch die eine Annäherung des Meßwertes an den eingestellten Referenzwert oder auch die Änderung des absoluten Meßwertes akustisch verdeutlicht wird. Zum Einschalten des Meßgerätes dient der Einschalter 30 und zum Anschließen der Meßleitungen Anschlußbuchsen 31.

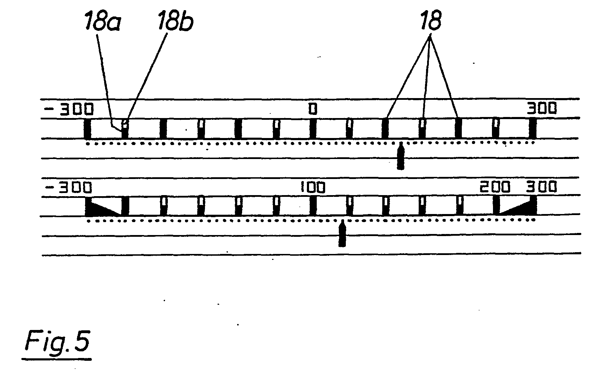

Da die Kosten des Meßgerätes wesentlich von dem erforderlichen Aufwand für die Ansteuerung des Displays abhängt, ist die Zahl der einzeln ansteuerbaren Flächensegmente auf das notwendige Minimum reduziert. Hierzu ist die Skala in ihrem Grundaufbau fest vorgegeben. Wie Figur 5 zeigt, kann aber die Länge der Skalenstriche 18 und damit begrenzt auch die Skalenaufteilung beeinflußt werden. Die Skalenstriche bestehen hierzu aus zwei getrennten Flächensegmenten 18a, 18b. Während alle Flächensegmente 18a gemeinsam angesteuert werden, können die Flächensegmente 18b einzeln der gewünschten Skalenteilung entsprechend zur Anzeige gebracht werden.

Bei einem mit dem Zoom-Schalter 14 vorgewählten Spreizungsfaktor paßt die Spreizung der Meßbereichsausschnitte im allgemeinen nicht unmittelbar mit der vorgegebenen Skalenteilung zusammen. Eine Skalenanpaßautomatik sorgt deshalb dafür, daß durch eine Feinabstimmung des Spreizungsfaktors eine Anpassung an die Skala erfolgt.

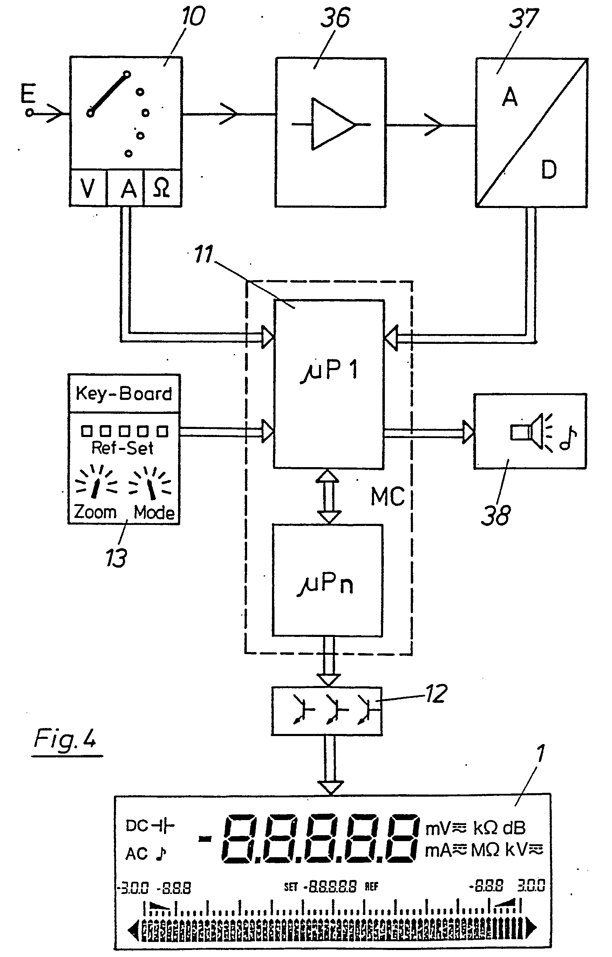

Das Meßgerät besitzt, wie Figur 4 zeigt, eine durch einen Mikrocomputer mit mindestens einem Mikroprozessor realisierte Steuerautomatik 11, die die von einer Meßeingabeeinheit 10 kommenden Meßdaten in Verbindung mit den an einer Bedienungseinheit 13 vorgegebenen Parametern, insbesondere für die Skalen- und die Referenzwerte, bewertet und umrechnet und die aufbereiteten Meßdaten über einen Anzeigentreiber 12 dem Display 1 als Steuersignale zuführt. Die Datenaufnahme des Mikrocomputers erfolgt einerseits unmittelbar von der Meßwerteingabeeinheit und andererseits nach Umsetzung der von der Meßwerteingabeeinheit 10 kommenden Signale in einer aus Buffer und Effektivwertwandler bestehenden Anpaßschaltung 36 sowie einem nachgeschalteten A/D-Wandler 37. Zur akustischen Signalabgabe besitzt der Mikrocomputer noch einen Ausgang für einen Referenz-Piper 38.

Zur Erläuterung der auf dem Display dargestellten Zeichen ist noch darauf hinzuweisen, daß alle Flächensegmente, die insgesamt ansteuerbar sind, in Fig. 1 und Fig. 4 dargestellt sind. Da die Zeichen auf dem Display nicht durch eine Matrixsteuerung sondern durch Ansteuerung einzelner den jeweiligen Zeichen entsprechende Flächensegmente erfolgt, können die Zeichen nicht wahlweise übereinander, an der selben Stelle, sondern nur wahlweise nebeneinander sichtbar gemacht werden. Im praktischen Betrieb werden selbstverständlich von den dargestellten Zeichen für die Stromartenanzeige 32 und für die Meßgrößenanzeige 33 jeweils nur eines eingeblendet. Entsprechendes gilt auch für die Ziffern 22, 26, die bei einer Ansteuerung aller sieben Segmente jeweils eine acht ergeben und für die Zeigermarken 17, von denen nur eine einzeln oder mehrere als Band angesteuert werden.

**Patentansprüche**

1. Verfahren zur Meßwertanzeige bei einem digitalen Meßgerät, mit folgenden Merkmalen:

auf einem Display (1) des Meßgerätes erfolgt eine quasi analoge Darstellung des Meßwertes derart, daß ansteuerbare Flächensegmente (20) entlang einer Meßwertskala (6, 7, 9) mit zugehöriger Beschriftung (22, 32, 33) ihre Stellung als Zeigermarke (17) oder Balkenanzeige (19) ändern

die Meßwertskala (6, 7, 9) gibt aus einem vorgegebenen Gesamtmeßbereich einen gespreizten Meßbereichsausschnitt (2) wieder, dessen Spreizungsfaktor einstellbar ist, so daß der Meßwert innerhalb des zur Anzeige gebrachten Meßbereichsausschnittes zu liegen kommt,

der Meßbereichsausschnitt (2) einschließlich zugehöriger, numerisch dargestellter Skalenwerte (23, 24) wird bei gleichbleibendem Gesamtmeßbereich (5) durch eine Steuerautomatik (11) umgeschaltet, sobald die Meßwerte vorgegebene Grenzwerte des Meßbereichsausschnittes (2) überschreiten,

die Steuerautomatik ermittelt die Änderungsgeschwindigkeit der Meßwerte und optimiert den Spreizungsfaktor dahingehend, daß bei größtmöglicher Spreizung die Meßwerte bei gleichbleibender Änderungsgeschwindigkeit den jeweiligen Meßbereichsausschnitt in einem vorgebbaren Zeitraum nicht überschreiten.

2. Verfahren zur Meßwertanzeige bei einem digitalen Meßgerät, mit folgenden Merkmalen:

auf einem Display (1) des Meßgerätes erfolgt eine quasi analoge Darstellung des Meßwertes derart. daß ansteuerbare Flächensegmente (20) entlang einer Meßwertskala (6, 7, 9) mit zugehöriger Beschriftung (22, 32, 33) ihre Stellung als Zeigermarke (17) oder Balkenanzeige (19) ändern,

die Meßwertskala (6, 7, 9) gibt aus einem vorgegebenen Gesamtmeßbereich einen gespreizten Meßbereichsausschnitt (2) wieder, dessen Spreizungsfaktor veränderbar ist, so daß der Meßwert innerhalb des zur Anzeige gebrachten Meßbereichsausschnittes zu liegen kommt,

der Meßbereichsausschnitt (2) wird bei gleichbleibendem Gesamtmeßbereich (5) durch eine Steuerautomatik (11) so umgeschaltet, daß er beidseitig zu einem auf Skalenmitte eingestellten numerisch angezeigten Referenzwert zu liegen kommt

während eines Abgleichvorgangs bewirkt die Steuerautomatik (11) eine stufige Änderung des Spreizungsfaktors derart, daß der innerhalb des Meßbereichsausschnittes liegende Meßwert jeweils den größtmöglichen Abstand zum Referenzwert hat.

3. Verfahren zur Meßwertanzeige nach einem der Ansprüche 1 oder 2, dadurch gekennzeichnet, daß eine Meßwerteingabeeinheit (10) zur Anpassung des Meßwertes dient und ihre Ausgangssignale einerseits zur Erfassung der Bereichsparameter unmittelbar und andererseits unter Zwischenschaltung einer Anpaßschaltung (36) und eines AD-Wandlers (37) einem Mikrocomputer (11) zugeführt werden und der Mikrocomputer als Steuerautomatik (11) wirkt und die Umsetzung des Meßwertes in einzelne zur Aktivierung der Flächensegmente des Displays (1) erforderliche Steuersignale vornimmt und über einen Anzeigentreiber (12) diesem zuführt, wobei über eine Bedienungseinheit (13) dem Mikrocomputer verschiedene den Meßbereich, die Spreizung des Meßbereichsausschnittes (2) und weitere die Ansteuerung der Flächensegmente (20) bestimmende Parameter vorgegeben werden.

4. Verfahren zur Meßwertanzeige nach einem der vorhergehenden Ansprüche, dadurch gekennzeichnet, daß die Zahl und der Abstand der Stufen des veränderbaren Spreizungsfaktors sowie der maximale von der Steuerautomatik wählbare Spreizungsfaktor von Hand eingestellt werden.

5. Verfahren zur Meßwertanzeige nach mindestens einem der vorhergehenden Ansprüche, dadurch gekennzeichnet, daß auf dem Display (1) durch die Ansteuerung der die quasi analoge Meßwertanzeige vermittelnden Flächensegmente gleichzeitig mit dem gespreizten Meßbereichsausschnitt (2) auch der zwischen Skalenanfangsund Skalenendwert (3, 4) liegende Gesamtmeßbereich (5) dargestellt wird, und beide Meßbereiche (2, 5) auf eine Skala (9) fallen, wobei der gespreizte Meßbereichsausschnitt (2) im mittleren Teil der Skala (9) zu liegen kommt und ein- oder beidseitig sich an den Meßbereichsausschnitt (2) anschließend Anfang und/oder Ende des Gesamtmeßbereiches (5) angeordnet werden und die über den gespreizten Meßbereichsausschnitt (2) hinausgehenden Teile des Gesamtmeßbereiches (5) entsprechend gedrängt werden.

6. Verfahren zur Meßwertanzeige nach mindestens einem der vorhergehenden Ansprüche, dadurch gekennzeichnet, daß die Flächensegmente des Displays in ihrer Form an die vorgesehenen Skalenvarianten angepaßt werden, und bezüglich ihrer Flächenausdehnung teilweise sehr unterschiedlich sind und daß zum Ansteuern der Flächensegmente diese gegenüber einer gemeinsamen Elektrode einzeln an Gegenpotential gelegt werden, oder zur Reduzierung der einzeln anzusteuernden Elektroden bei Anwendung geeigneter Multiplexverfahren mehrere Gegenelektroden gebildet werden.

7. Verfahren zur Meßwertanzeige nach mindestens einem der vorhergehenden Ansprüche, dadurch gekennzeichnet, daß die Skala (6, 7, 9) mit einer festen Skalenteilung versehen wird, die unabhängig vom gewählten Gesamtmeßbereich (5) und dem jeweiligen Meßbereichsausschnitt (2) gleich bleibt und durch Änderung der Länge der Skalenstriche (18) und der Skalenbeschriftung eine Anpassung erfolgt und die invariablen Teile der Skala (6, 7, 9) gemeinsam angesteuert oder durch Aufdruck fest vorgegeben werden.

8. Verfahren zur Meßwertanzeige nach mindestens einem der vorhergehenden Ansprüche, dadurch gekennzeichnet, daß die zur Darstellung der Zeigermarke (17) ansteuerbaren Flächensegmente (20) in gleichem Abstand parallel nebeneinander vom Skalenanfang (3) bis zum Skalenende (4) angeordnet werden, und die Zahl und Position dieser Flächensegmente (20) so gewählt wird, daß an jedem Skalenstrich (18) ein Flächensegment (20) zu liegen kommt und weitere Flächensegmente (20) zwischen den Skalenstrichen (18) angeordnet sind.

9. Verfahren zur Meßwertanzeige nach mindestens einem der vorhergehenden Ansprüche, dadurch gekennzeichnet, daß Anfangs- und Endwert von Meßbereichsausschnitt und Gesamtmeßbereich sowie im allgemeinen auch der Skalenmittenwert mit steuerbaren Ziffern (22) angezeigt werden, zur Anzeige des momentanen Meßwertes (Istwertes) jedoch eine flächenmäßig wesentlich größere Ziffernanzeige (26) dient.

10. Verfahren zur Meßwertanzeige nach mindestens einem der Ansprüche 8 bis 9, dadurch gekennzeichnet, daß alle oder einige Skalenstriche (18) aus je zwei getrennt ansteuerbaren Strichsegmenten (18a, 18b) bestehen, die gemeinsam angesteuert die Länge des jeweiligen Skalenstriches (18) vergrößern und die vorzugsweise durch einen Mikrocomputer realisierte Steuerautomatik (11) dafür sorgt, daß bei einer Umschaltung des Meßbereiches die längeren Skalenstriche an einer Stelle zu liegen kommen, die eine leicht lesbare Unterteilung des eingestellten Meßbereichs gewährleistet.

11. Verfahren zur Meßwertanzeige nach Anspruch 1, dadurch gekennzeichnet, daß die Steuerautomatik (11) die Umschaltung so vornimmt daß sich eine Überlappung zweier aufeinanderfolgender Meßbereichausschnitte (2) ergibt, die vorzugsweise einem halben Meßbereichsausschnitt (2) entspricht.

12. Verfahren zur Meßwertanzeige nach mindestens einem der vorhergehenden Ansprüche, dadurch gekennzeichnet, daß die automatische Umschaltung des Meßbereichsausschnittes durch eine Zeitschaltung verzögert ist und die Verzögerungszeit durch einen Schalter (15) stufig und/oder durch ein Potentiometer stetig einstellbar ist.

**Revendications**

1. Procédé d'affichage de valeurs mesurées sur un appareil de mesure numérique, présentant les caractéristiques suivantes:

une représentation quasiment analogique de la valeur mesurée s'effectue sur un afficheur (1) de l'appareil de mesure de telle sorte que des segments de surface (20) activables changent de position, en tant qu'aiguille indicatrice (17) ou de barre indicatrice (19), le long d'une échelle (6, 7, 9) comportant des inscriptions correspondantes (22, 32, 33),

l'échelle (6, 7, 9) reproduit sous une forme élargie une partie (2) de la gamme de mesure totale, partie dont le facteur d'élargissement est réglable, de manière que la valeur mesurée vienne se placer à l'intérieur de la partie affichée de la gamme de mesure,

la partie affichée (2) de la gamme de mesure y compris les valeurs d'échelle (23, 24) correspondantes, représentées numériquement, est commutée par un dispositif de commande automatique (11), sans modification de la gamme de mesure totale (5), dès que les valeurs mesurées dépassent des limites prédéterminées de ladite partie (2) de la gamme de mesure,

le dispositif de commande automatique (11) détermine la vitesse de variation des valeurs mesurées et optimise le facteur d'élargissement de telle manière que pour un facteur d'élargissement maximal, et pour une vitesse de variation constante, les valeurs mesurées ne sortent pas de ladite partie de la gamme de mesure pendant une période de temps pouvant être prédéterminée.

2. Procédé d'affichage de valeurs mesurées sur un appareil de mesure numérique présentant les caractéristiques suivantes:

une représentation quasiment analogique de la valeur mesurée s'effectue sur un écran (1) de l'appareil de mesure de telle sorte que des segments de surface (20) activables, changent de position, en tant qu'aiguille indicatrice (17) ou de barre indicatrice (19), le long d'une échelle (6, 7, 9) comportant des inscriptions correspondantes (22, 32, 33),

l'échelle (6, 7, 9) reproduit sous une forme élargie une partie (2) de la gamme de mesure totale, partie dont le facteur d'élargissement peut être modifié, de manière que la valeur mesurée vienne se placer à l'intérieur de la partie affichée de la gamme de mesure,

la partie affichée (2) de la gamme de mesure est commutée, sans modification de la gamme de mesure totale (5), par un dispositif de commande automatique (11) de telle sorte qu'elle vienne se placer de part et d'autre d'une valeur de référence indiquée numériquement au milieu de l'échelle,

pendant une opération de réglage, le dispositif de commande automatique (11) provoque une modification par paliers du facteur d'élargissement de telle sorte que la valeur mesurée se trouvant à l'intérieur de la partie de gamme de mesure soit à une distance maximale de la valeur de référence.

3. Procédé d'affichage de valeurs mesurées selon la revendication 1 ou 2, caractérisé en ce qu'une unité d'entrée de valeurs mesurées (10) sert à l'adaptation de la valeur mesurée et ses signaux de sortie sont transmis à un microprocesseur (11) d'une part directement pour déterminer les paramètres de gamme et d'autre part par l'intermédiaire d'un circuit d'adaptation (36) et d'un convertisseur analogique-numérique (37) et le microprocesseur agit en tant que dispositif de commande automatique (11) et assure la conversion de la valeur mesurée en différents signaux de commande nécessaires pour activer les segments de surface de l'afficheur (1) et les transmet audit afficheur par l'intermédiaire d'un déclencheur d'affichage (12), différents paramètres qui déterminent la gamme de mesure, l'élargissement de la partie de gamme de mesure (2) et l'activation des segments de surface (20) étant entrés préalablement dans le microprocesseur par une unité de sélection (13).

4. Procédé d'affichage de valeurs mesurées selon l'une des revendications précédentes, caractérisé en ce que le nombre et l'écartement des paliers du facteur d'élargissement variable ainsi que le facteur d'élargissement maximal pouvant être sélectionné par le dispositif de commande automatique sont réglés manuellement.

5. Procédé d'affichage de valeurs mesurées selon l'une des revendications précédentes, caractérisé en ce que l'activation des segments de surface assurant l'affichage quasiment analogique des valeurs mesurées entraîne la représentation sur l'afficheur (1), en même temps que de la partie élargie (2) de la gamme de mesure, également de la gamme totale de mesure (5) se trouvant entre la valeur de début d'échelle et la valeur de fin d'échelle (3, 4) et les deux gammes de mesure (2, 5) tombent sur une échelle (9), la partie élargie (2) de la gamme de mesure se plaçant dans la zone médiane de l'échelle (9) et le début et/ou la fin de la gamme totale de mesure (5) se raccordant d'un côté ou de part et d'autre de ladite partie (2) de la gamme de mesure et les parties de la gamme totale de mesure (5) dépassant la partie élargie (2) de la gamme de mesure étant contractées de manière correspondante.

6. Procédé d'affichage de valeurs mesurées selon l'une des revendications précédentes, caractérisée en ce que les segments de surface de l'afficheur sont adaptés de par leur forme aux variantes d'échelles prévues et sont partiellement très différents du point de vue de leur étendue et en ce que l'activation des segments de surface s'effectue en plaçant séparément lesdits segments à un potentiel inverse par rapport à une électrode commune ou en ce que pour réduire le nombre des électrodes devant être activées séparément, plusieurs contre-électrodes sont formées en utilisant des procédés multiplex appropriés.

7. Procede d'affichage de valeurs mesurées selon l'une des revendications précédentes, caractérisé en ce que l'échelle (6, 7, 9) est munie d'une graduation fixe qui reste constante quelles que soient la gamme totale de mesure (5) et la partie élargie (2) de la gamme de mesure et est adaptée par une modification de la longueur des traits d'échelle (18) et des inscriptions d'échelle et en ce que les parties invariables de l'échelle (6, 7, 9) sont activées ensemble ou sont prédéterminées de manière fixe par impression.

8. Procédé d'affichage de valeurs mesurées selon l'une des revendications précédentes, caractérisé en ce que les segments de surface (20) po'uvant être activés pour représenter l'aiguille indicatrice (17) sont disposés à distances égales parallèlement les uns à côté des autres du début (3) à la fin (4) de l'échelle et en ce que le nombre et la position de ces segments de surface (20) sont choisis de telle sorte qu'un segment de surface (20) viennne se placer sur chaque trait d'échelle (18) et que d'autres segments de surface (20) soient disposés entre les traits d'échelle (18).

9. Procédé d'affichage de valeurs mesurées selon l'une des revendications précédentes, caractérisé en ce que la valeur de début et la valeur de fin de la partie de gamme de mesure et de la gamme totale de mesure ainsi que généralement la valeur de milieu d'échelle sont indiquées par des chiffres (22) pouvant être activés et en ce que des chiffres (26) considérablement plus grands servent à visualiser la valeur mesurée momentanée (valeur effective).

10. Procédé d'affichage de valeurs mesurées selon l'une des revendications 8 à 9, carcatérisé en ce que tous les traits d'échelle (18) ou certains traits sont composés chacun de deux segments de trait (18a, 18b) pouvant être activés séparément qui, activés ensemble, augmentent la longueur du trait d'échelle (18) et en ce que le dispositif de commande automatique (11) réalisé de préférence sous la forme d'un microprocesseur veille à ce qu'en cas de commutation de la gamme de mesure, les traits d'échelle plus longs viennent se placer à un endroit qui assure une subdivision facilement lisible de la gamme de mesure réglée.

11. Procédé d'affichage de valeurs mesurées selon la revendication 1, caractérisé en ce que le dispositif de commande automatique (11) réalise la, commutation de telle sorte que l'on obtienne un chevauchement de deux parties (2) successives de la gamme de mesure, chevauchement qui correspond de préférence à une demi-partie de gamme de mesure (2).

12. Procédé d'affichage de valeurs mesurées selon l'une des revendications précédentes, caractérisé en ce que la commutation automatique de la partie de gamme de mesure est retardée par un circuit de temporisation et en ce que le retard est réglable par paliers par un commutateur (15) et/ou en continu par un potentiomètre.

## Claims

1. Process for displaying measured values in a, digital measuring device, having the following features:
a quasi-analog representation of the measured value occurs on a display (1) of the measuring device, in such a way that actuable surface segments (20) along a measured value scale (6, 7, 9) with associated labelling (22, 32, 33) change their setting as pointer marker (17) or bar display (19),
the measured value scale (6, 7, 9) reproduces from a predetermined overall measuring range an expanded measuring range excerpt (2), the expansion factor of which can be set, so that the measured value comes to lie within the measuring range excerpt displayed,
the measuring range excerpt (2) including associated numerically represented scale values (23, 24) is switched over in the case of a constant overall measuring range (5) by means of an automatic control (11), as soon as the measured values exceed predetermined limit values of the measuring range excerpt (2),
the automatic control calculates the change speed of the measured values and optimizes the expansion factor to the effect that, with the largest possible expansion, and in the case of a constant change speed, the measured values do not exceed the respective measuring range excerpt in a predeterminable time period.

2. process for displaying measured values in a digital measuring device, having the following features:
a quasi-analog representation of the measured value occurs on a display (1) of the measuring device, in such a way that actuable surface segments (20) along a measure value scale (6, 7, 9) with associated labelling (22, 32, 33) change their setting as pointer marker (17) or bar display (19),
the measured value scale (6, 7, 9) reproduces from a predetermined overall measuring range an expanded measuring range excerpt (2), the expansion factor of which is changeable, with the result that the measured value comes to lie within the measuring range excerpt displayed,
the measuring range excerpt (2) is switched over with constant overall measuring range (5) by means of an automatic control (11), in such a way that it comes to lie on both sides of a numerically indicated reference value set at the scale centre,
during an adjustment process, the automatic control (11) brings about a stepped change of the expansion factor in such away that the measured value lying within the measuring range excerpt in each case has the greatest possible distance from the reference value.

3. Process for displaying measured values according to one of Claims 1 or 2, characterized in that a measured value input unit (10) serves for matching the measured value, and its output signals are fed, on the one hand directly, for the purpose of acquiring the range parameters, and, on the other hand, with the intermediate connection of a matching circuit (36) and of an analog-to-digital converter (37), to a microcomputer (11), and the microcomputer acts as automatic control (11) and performs the conversion of the measured value into individual control signals required for the activation of the surface segments of the display (1) and feeds them to the latter via a display driver (12), various parameters which determine the measuring range, the expansion of the measuring range excerpt (2) and also the actuation of the surface segments (20) being preset for the microcomputer via an operating unit (13).

4. Process for displaying measured values according to one of the preceding claims, characterized in that the number and the distance of the steps of the changeable expansion factor as well as the maximum expansion factor which can be selected by the automatic control are set by hand.

5. Process for displaying measured values according to at least one of the preceding claims, characterized in that, by virtue of the actuation of the surface segments, which convey the quasi-analog measured value display, simultaneously with the expanded measuring range excerpt (2), the overall measuring range (5) lying between the scale start value and scale end value (3, 4) is also represented on the display (1), and both measuring ranges (2, 5) occur on one scale (9), the expanded measuring range excerpt (2) coming to lie in the central part of the scale (9), and the start and/or end of the overall measuring range (5) being arranged adjoining on one or both sides of the measuring range excerpt (2), and the parts of the overall measuring range (5) extending beyond the expanded measuring range excerpt (2) being correspondingly compressed.

6. Process for displaying measured values according to at least one of the preceding claims, characterized in that the shape of the surface segments of the display is matched to the scale variants provided, and, in respect of their surface extension, are in some cases very different, and in that for the purpose of actuating the surface segments, the latter are connected individually to opposite potential in respect of a common electrode, or for the purpose of reducing the electrodes to be individually actuated, a plurality of opposite electrodes are formed using suitable multiplex processes.

7. Process for displaying measured values according to at least one of the preceding claims, characterized in that the scale (6, 7, 9) is provided with a fixed scale division, which remains the same irrespective of the selected overall measuring range (5) and the respective measuring range excerpt (2), and matching occurs by changing the length of the scale marks (18) and of the scale labelling, and the invariable parts of the scale (6, 7, 9) are actuated in common or are permanently predetermined by overprinting.

8. Process for displaying measured values according to at least one of the preceding claims, characterized in that the surface segments (20) which are actuable for the purpose of representing the pointer marker (17) are arranged at the same distance parallel and adjacent to one another from the scale start (3) to the scale end (4), and the number and position of these surface segments (20) is selected in such a way that a surface segment (20) comes to lie at each scale mark (18), and further surface segments (20) are arranged between the scale marks (18).

9. Process for displaying measured values according to at least one of the preceding claims, characterized in that the start and end value of the measuring range excerpt and overall measuring range as well as in general also the scale centre value are displayed with controllable digits (22), but a digit display (26) which is considerably larger in area serves for displaying the instantaneous measured value (actual value).

10. Process for displaying measured values according to at least one of Claims 8 to 9, characterized in that all or some of the scale marks (18) consist of in each case two separately actuable mark segments (18a, 18b) which, when actuated together, increase the length of the respective scale mark (18), and the automatic control (11) preferably realized by means of a microcomputer ensures that, in the case of a switching over of the measuring range, the longer scale marks come to lie at a point which guarantees an easily readable subdivision of the set measuring range.

11. Process for displaying measured values according to Claim 1, characterized in that the automatic control (11) performs the switching over in such a way that an overlapping of two successive measuring range excerpts (2) occurs, which preferably corresponds to one half of a measuring range excerpt (2).

12. Process for displaying measured values according to at least one of the preceding claims, characterized in that the automatic switching over of the measuring range excerpt is delayed by means of a time circuit, and the delay time can be set non-continuously by means of a switch (15) and/or continuously by means of a potentiometer.

EP 0 157 135 B1

EP 0 157 135 B1

Fig.2

Fig.3

2

Fig.4

*Fig.5*